# EUROPEAN PATENT APPLICATION

(11) **EP 3 401 273 A1**
(43) Date of publication of application: **14.11.2018**
(21) Application number: 17208918.7
(22) Date of filing: 20.12.2017
(51) Int. Cl.: B81B 7/00, B81B 7/02, B81C 1/00

(54) **METHOD OF MAKING A MULTI-CAVITY MEMS DEVICE WITH DIFFERENT PRESSURES IN THE CAVITIES**

(30) Priority: 22.12.2016 SE 1651737
(71) Applicant: Silex Microsystems AB, 175 26 Järfälla (SE)
(72) Inventor: WESTIN, Håkan, 746 91 BÅLSTA (SE); WICKERT, Peter, 172 32 SUNDBYBERG (SE); EBEFORS, Thorbjörn, 141 41 HUDDINGE (SE)
(74) Representative: Brann AB

(57) **Abstract**

The present invention relates to a method of making a MEMS device (40) requiring more than one cavity (20', 20"), each cavity having different atmospheres in terms of pressure and/or composition, and a MEMS device having cavities (20', 20") with different atmospheres. The different atmospheres are obtained by combined use of gettering structures (26) and implanted gaseous species (28), which upon thermal activation removes unwanted species (gettering) from cavities (20', 20") and provides controlled atmosphere by release of implanted gas in the cavities (20', 20").

## Description

The present invention relates to a method of making a micro-mechanical device such as a MOEMS or a MEMS device requiring more than one cavity, each cavity having different atmospheres in terms of pressure and/or composition, and a MEMS device having cavities with different atmospheres.

### Background of the Invention

In the continuous strive to reduce size of micro components for use in e.g. mobile phones and other electronic equipment; the packaging of functions of different types on one and the same chip is an important requirement.

For example it is desirable to provide accelerometers, gyros, oscillators and other MEMS components such as IR sensor detectors on the same chip in separate sealed cavities. Such components comprise movable members or sensor elements relying on thermal conductivity which each requires a specific atmosphere in order to function properly. Some components require a damping atmosphere in order not to cause unwanted self-oscillation, whereas others require vacuum or at least very low pressures in order to function properly. Some devices like gas sensor absorption requires over pressure inside the cavities.

These requirements are contradictory and require special measures in the manufacturing of the devices in question.

The state of the art offers a technology of using so called "getters" inside cavities in order to handle and control the atmosphere inside closed cavities.

Getter materials are primarily used for preventing a long term increase of cavity pressure caused by degassing from the wafer material. The getter absorbs released gas molecules and thus the "nominal" pressure can be preserved.

The getter technology has been used by e.g. Fraunhofer (US-8,546,928) to provide a solution to the problem of providing cavities with different pressures. In this patent there is disclosed a multiple component which is to be subsequently individualized by forming components containing active structures, in addition to a corresponding component which can be used in microsystem technology systems. The multiple component and/or component comprises a flat substrate and also a flat cap structure which are bound to each other such that they surround at least one first and one second cavity per component, which are sealed against each other and towards the outside.

The first of the two cavities is provided with getter material and due to the getter material said first cavity has a different internal pressure and/or a different gas composition than the second cavity.

Instead of providing getter materials inside cavities, it is also possible to provide a gettering function by transforming the internal surfaces of the cavity so as to create reactive voids.

US-5,840,590 discloses impurity gettering in silicon wafers which is achieved by a new process consisting of helium ion implantation followed by annealing. This treatment creates cavities whose internal surfaces are highly chemically reactive due to the presence of numerous silicon dangling bonds. For two representative transition-metal impurities, copper and nickel, the binding energies at cavities were demonstrated to be larger than the binding energies in precipitates of metal silicide, which constitutes the basis of most current impurity gettering. As a result the residual concentration of such impurities after cavity gettering is smaller by several orders of magnitude than after precipitation gettering. Additionally, cavity gettering is effective regardless of the starting impurity concentration in the wafer, whereas precipitation gettering ceases when the impurity concentration reaches a characteristic solubility determined by the equilibrium phase diagram of the silicon-metal system. The strong cavity gettering was shown to induce dissolution of metal-silicide particles from the opposite side of a wafer.

US-7,564,082 relates i.a. to a semiconductor structure, comprising a gettering region proximate to a device region in a semiconductor wafer. The gettering region includes a precisely-determined arrangement of a plurality of precisely-formed voids through a surface transformation process. Each of the voids has an interior surface that includes dangling bonds such that the plurality of voids getter impurities from the at least one device region. The structure includes a transistor formed using the device region. The transistor includes a gate dielectric over the device region, a gate over the gate dielectric, and a first diffusion region and a second diffusion region formed in the device region. The first and second diffusion regions are separated by a channel region formed in the device region between the gate and the proximity gettering region.

In DE 10 2012 202 183 A1 there is disclosed a micro-mechanical structure having a cavity in which there is provided a layer of material for releasing a gas into the cavity.

In US 2011/0048129 A1 there is disclosed an inertial sensor comprising a gas-generating material applied inside a cavity to provide a desired pressure inside said cavity.

In applicants own SE 538 346 there is disclosed a method of providing different atmospheres in cavities using controlled release of gaseous species from a substrate.

### Summary of the Invention

The object of the present invention is to extend the scope of possibilities for providing MEMS devices according to the preamble. In particular it also aims to improve the techniques for tailoring the atmosphere in the devices to the actual needs, and also to reduce manufacturing costs.

This object is met in a first aspect by a method defined in claim 1.

Thus, a method of making a MEMS device comprising at least two cavities each cavity having a different atmosphere in its respective cavity comprises providing a first wafer and a second wafer. Atoms or ions of one or more gaseous species are implanted in a surface of at least one of the wafers in a limited area thereof, and a gettering material is provided on at least one of the wafers in areas where no implanting of said atoms or ions has been made. The wafers are bonded together such that sealed cavities are created between said wafers. Then the resulting structure is subjected to conditions so as to activate the getter and/or to release the implanted gaseous species. The relative amounts of getter and implanted atoms or ions of one or more gaseous species are selected such that different pressures and/or atmospheres will prevail in the cavities.

In one embodiment the steps of implanting atoms or ions and providing a gettering material are performed in different cavities.

In another embodiment the steps of implanting atoms or ions and providing a gettering material are performed in at least one cavity and at least one other cavity is not subjected to either implanting or providing a gettering material.

In a further embodiment the steps of implanting atoms or ions and providing a gettering material are performed in a plurality of cavities, wherein some cavities are subjected to both steps, some cavities are subjected to either step, and some cavities are not subjected to either.

Preferably, the first and second wafers are flat and the cavities are formed by providing an intermediate wafer having an opening. The opening optionally has at least one divider member functioning as a partition wall to seal the cavities hermetically from each other upon bonding, or wherein at least one of the first and second wafers have divider elements functioning as a partition wall to seal the cavities hermetically from each other, upon bonding with the intermediate wafer.

In one embodiment at least one of the first and second wafers have depression(s) formed in their surface, and the cavities are formed by bonding the wafers together, wherein there is/are provided (a) divider element(s) functioning as (a) partition wall(s) to seal the cavities hermetically from each other upon bonding.

In one embodiment the first and second wafers are flat and wherein the cavities are formed in that the bonding material acts as a spacer.

Suitably a functional component is provided in at least one cavity. The functional component is preferably selected from the group consisting of gyro, an accelerometer, a strain gauge, a piezoresistive component, pressure sensors, bolometers, MUT (Micromachined Ultrasonic Transducer), gas sensors.

In a second aspect there is provided a MEMS device comprising at least two cavities each having a different pressure and/or atmosphere. The respective pressure and/or atmosphere have been obtained by the provision of either a gettering material or an outgassing material or a combination thereof in at least one of the cavities.

Further scope of applicability of the present invention will become apparent from the detailed description given hereinafter and the accompanying drawings which are given by way of illustration only, and thus not to be considered limiting on the present invention, and wherein
Fig. 1 illustrates a MEMS device having two cavities with different pressures;
Fig. 2 illustrates another embodiment of a MEMS device having two cavities with different pressures;
Fig. 3 illustrates a further embodiment of a MEMS device having two cavities with different pressures;
Fig. 4 schematically illustrates a MEMS device having two cavities with a getter in one cavity and implanted material in another;
Fig. 5 illustrates a MEMS device having two cavities with a getter and implanted material in one cavity and optionally implanted material in another;
Fig. 6 illustrates a MEMS device having two cavities with getter and implanted material in both cavities;
Fig. 7 illustrates a MEMS device having two cavities with a thin membrane covering the cavities and with a strain gauge on the outside of the cavity on the membrane and with getter and implanted material in one cavity;
Fig. 8 illustrates provision of getter and/or implanted material on other surfaces;

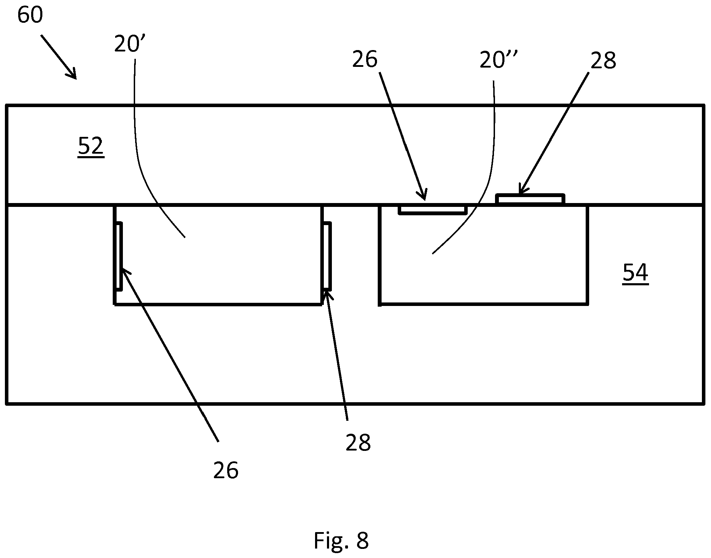

Fig. 8 shows a matrix of cavities on a wafer with different combinations of getter and implanted Argon in cavities;

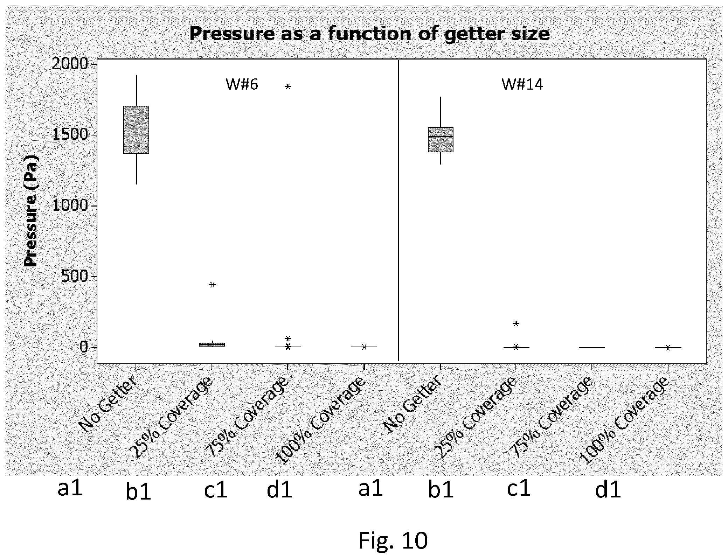

Fig. 10 is a graph illustrating pressure as a function of getter size;

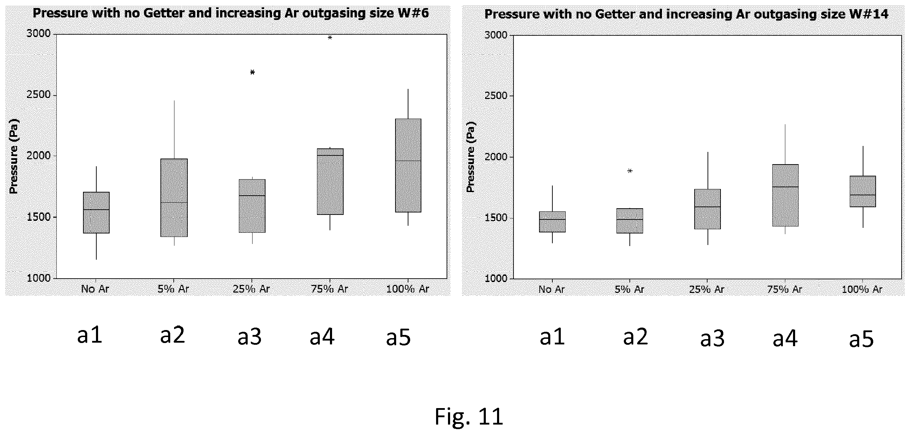

Fig. 11 is pressure with no getter and increasing Argon outgassing for two different test wafers; and

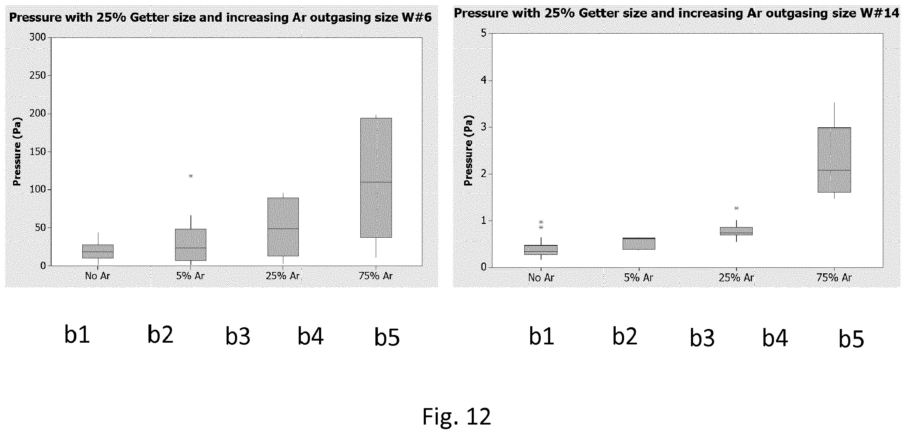

Fig. 12 shows pressure as a function of some getter and increasing Argon outgassing for two different test wafers.

### Detailed Description of Preferred Embodiments

The invention is applicable generally to any micromechanical structure, e.g. MEMS (Micro-Electro-Mechanical Systems) and/or MOEMS (Micro-Opto-Electro-Mechanical Systems) structures. In the specification and claims the term MEMS will be used to cover the notion of micromechanical structures in general.

A "getter" is a reactive material that is deliberately placed inside a vacuum system for the purpose of improving the efficiency of that vacuum by scavenging unwanted contaminates. Essentially, when gas molecules strike the getter material, they combine with it chemically or by adsorption so as to be removed from the environment. In other words, a getter eliminates even minute amounts of unwanted gases from the evacuated space.

For the purpose of this invention the term "cavity" is taken to mean an unfilled space within a mass, and especially a hollowed-out space, or a confined space between two surfaces. The provision of structural items inside the cavity is possible without changing the notion "cavity".

Thus it can mean both the sealed space obtained by closing a depression in a substrate by bonding another substrate over the depression, whereby the other substrate can be flat or itself exhibit a matching depression. However, it can also mean the empty space between wafers created by the finite thickness of bonding materials, such as in eutectic bonding, which can exhibit a thickness of a few µm, say up to 5 µm or thereabout.

The term "atmosphere" is herein taken to mean a gaseous condition determined by pressure and/or composition of gaseous species.

In the present invention the getter is used for controlling the atmosphere. The getter is applied to the wafer by methods disclosed in the patent US-7,180,163 "SUPPORT WITH INTEGRATED DEPOSIT OF GAS ABSORBING MATERIAL FOR MANUFACTURING MICROELECTRONIC, MICROOPTOELECTRONIC OR MICROMECHANICAL DEVICES", (SAES Getter). The getter material can be a metal such as Zr, Ti, Nb, Ta, V; an alloy of these metals or one or more of these elements and additional element(s), preferably selected from Cr, Mn, Fe, Co, Ni, Al, Y, La and rare-earths, like binary alloys Ti-V, Zr-V, Zr-Fe and Zr-Ni, ternary alloys like Zr-Mn-Fe or Zr-V-Fe, or alloys with more components. In a preferred embodiment of the invention, getter materials are titanium, zirconium.

In a more preferred embodiment of the invention, getter materials are titanium-based according to fabrication processes as presented by CHIDAMBARAM et al in "Titanium-Based Getter Solution for Wafer-Level MEMS Vacuum Packaging", Journal of ELECTRONIC MATERIALS, March 2013, Volume 42, Issue 3, pp 485-491.

However, instead of providing getter materials inside cavities, it is also possible to provide a gettering function by transforming the internal surfaces of the cavity so as to create reactive voids, as discussed in the preamble. Reference is made to i.a. US-5,840,590 and US-7,564,082 for methods.

Implantation of gaseous species (ions or molecules; in the examples below Argon was used), can be performed e.g. by using an ion implanter or a plasma chamber. Although Argon has been used herein in examples, any noble gas or any other gas that would not react with a getter would be used.

Examples of gases the will react with gettering materials are O₂, N₂, H₂, water vapour to mention a few.

An important basis for the invention is that when joining structures to form closed cavities, which normally takes place in a so called bonder, it will not be possible to obtain a proper vacuum, and therefore gettering is used as a method to rid the cavities of unwanted materials. This effect is used in the invention to provide controlled atmosphere, as will be disclosed in more detail below.

In its most general form the invention provides a method of making a MEMS device comprising at least two cavities each cavity having a different atmosphere in its respective cavity which comprises providing a first wafer and a sealing structure. The sealing structure can be a second wafer used as a lid for hermetically sealing cavities formed upon joining the first and second wafers or a membrane covering a depression formed in the first wafer so as to form a cavity. Atoms or ions of one or more gaseous species are implanted in a surface of at least one of the first wafer and the sealing structure in a limited area thereof, and a gettering structure and/or material is provided on at least one of the first wafer and the sealing structure in areas where no implanting of said atoms or ions has been made. The first wafer is sealed using the sealing structure such that sealed cavities are created between said first wafer and the sealing structure. The resulting structure is then subjected to conditions so as to activate the getter and/or to release the implanted gaseous species. The relative amounts of getter and implanted atoms or ions of one or more gaseous species are selected such that different pressures and/or atmospheres will prevail in the cavities.

The gettering structure is in one embodiment a deposited material, preferably a metal selected from a metal such as Zr, Ti, Nb, Ta, V; an alloy of these metals or one or more of these elements and additional element(s), preferably selected from Cr, Mn, Fe, Co, Ni, Al, Y, La and rare-earths, like binary alloys Ti-V, Zr-V, Zr-Fe and Zr-Ni, ternary alloys like Zr-Mn-Fe or Zr-V-Fe, or alloys with more components. In another embodiment the gettering structure is a modified surface of wafer material.

According to one embodiment of the invention there is provided a method of making a MEMS device comprising at least two cavities each cavity having a different atmosphere in its respective cavity comprises providing a first wafer and a second wafer. Atoms or ions of one or more gaseous species are implanted in a surface of at least one of the wafers in a limited area thereof, and a gettering material is provided on at least one of the wafers in areas where no implanting of said atoms or ions has been made. The wafers are bonded together such that sealed cavities are created between said wafers. Then the resulting structure is subjected to conditions so as to activate the getter and/or to release the implanted gaseous species. The relative amounts of getter and implanted atoms or ions of one or more gaseous species are selected such that different pressures and/or atmospheres will prevail in the cavities.

In one embodiment the steps of implanting atoms or ions and providing a gettering material are performed in different cavities.

In another embodiment the steps of implanting atoms or ions and providing a gettering material are performed in at least one cavity and at least one other cavity is not subjected to either implanting or providing a gettering material.

In a further embodiment the steps of implanting atoms or ions and providing a gettering material are performed in a plurality of cavities, wherein some cavities are subjected to both steps, some cavities are subjected to either step, and some cavities are not subjected to either.

Preferably, the first and second wafers are flat and the cavities are formed by providing an intermediate wafer having an opening. The opening optionally has at least one divider member functioning as a partition wall to seal the cavities hermetically from each other upon bonding, or wherein at least one of the first and second wafers have divider elements functioning as a partition wall to seal the cavities hermetically from each other, upon bonding with the intermediate wafer.

In one embodiment at least one of the first and second wafers have depression(s) formed in their surface, and the cavities are formed by bonding the wafers together, wherein there is/are provided (a) divider element(s) functioning as (a) partition wall(s) to seal the cavities hermetically from each other upon bonding.

In one embodiment the first and second wafers are flat and wherein the cavities are formed in that the bonding material acts as a spacer.

Suitably a functional component is provided in at least one cavity. The functional component is preferably selected from the group consisting of a gyro, an accelerometer, a strain gauge, a piezoresistive component, pressure sensors, bolometers, MUT (Micromachined Ultrasonic Transducer), gas sensors.

In a second aspect there is provided a MEMS device comprising at least two cavities each having a different pressure and/or atmosphere. The respective pressure and/or atmosphere have been obtained by the provision of either a gettering material or an outgassing material or a combination thereof in at least one of the cavities.

The MEMS device suitably comprises a functional component (such as optical, electrical or mechanical) in at least one cavity.

Preferably the cavities are placed side by side on the same height.

Different embodiments and alternative ways of implementing the invention will now be described.

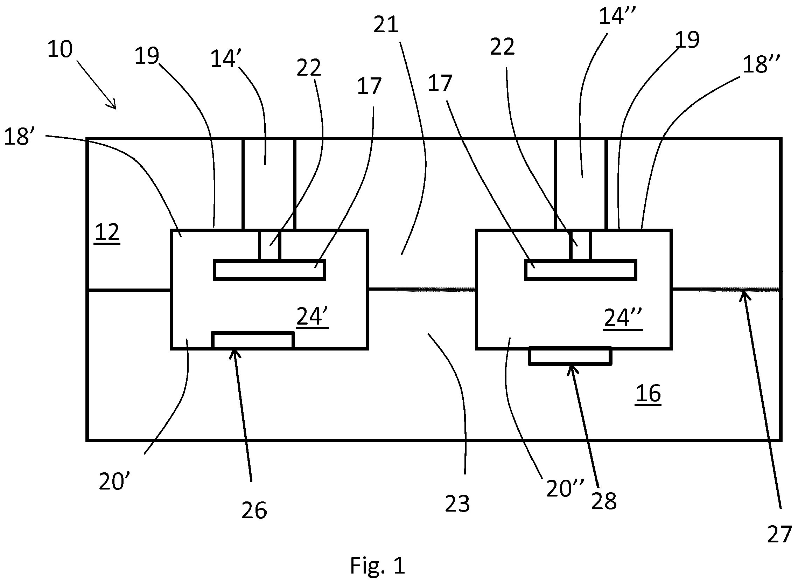

Thus, Fig. 1 illustrates an embodiment implemented in a device 10, comprising a first wafer 12, preferably a silicon wafer, optionally comprising vias 14', 14" suitably made of a wafer native material, and a cap wafer 16, suitably made of silicon. Cavities 24', 24" are provided inside the device 10. Other wafer and via materials are possible, such as glass wafers and metal vias. Thus, a via 14', 14" extends from the interior of a device 10, i.e. from a cavity 24', 24" in the device to the exterior of the device.

Two depressions, 18', 18" are provided in the via wafer, the optional vias 14', 14" extending through the via wafer 12 so as to form a contact surface in the bottom 19 of the cavities 24', 24" (the "roof" as seen in the figure). A divider member 21 separates the depressions 18', 18".

Functional components 17 can be attached to the vias 14', 14" by means of a spacer element 22 so as to provide free movements for the component, if required. In a test device the component is a so called Process Control Monitor (PCM). This component is used for measuring the pressure inside the cavity for validation of the effect of the invention.

In a "commercial" device the functional component would be a gyro, an accelerometer, a strain gauge, a piezoresistive component, pressure sensors, bolometers, MUT (Micromachined Ultrasonic Transducer), gas sensors etc.

The cap wafer 16 can also be provided with two depressions 20', 20" to accommodate for movements of the functional components 17 if needed. These depressions are also like in the via wafer 12 separated by a divider member 23. This divider member 23 and the divider member 21 together form a partition wall defining two hermetically sealed cavities 24', 24" when the cap wafer 16 and the via wafer 14 are bonded together.

The wafers 12, 16 are bonded using suitable bonding techniques, e.g. eutectic bonding, using frame structures (not shown) of gold (Au) enclosing the cavity region, forming a hermetic seal 27 between the wafers 12, 16. The eutectic system used can be poly-Si + Au/Sn or other metal alloys forming a eutectic for bonding purposes at a suitable temperature. Example Al-Ge or other Tin based alloys (PbSn, AgSn, to mention a couple).

Eutectic bonding is done at low temperature and thus the getter will survive.

Other bonding methods that can be mentioned are fusion bonding, glass frit, polymer adhesive, tape, thermal compression, anodic bonding, or combinations thereof.

In the embodiment in Fig. 1 there is provided a getter material 26 in one cavity 24' and a noble gas 28, such as Argon, is implanted in the wafer material in the other cavity 24".

The desired pressure in the cavities 20', 20" is set by adjusting the amount of getter and implanted noble gas Argon, respectively in the cavities.

The cavities 24', 24" can be obtained in different ways.

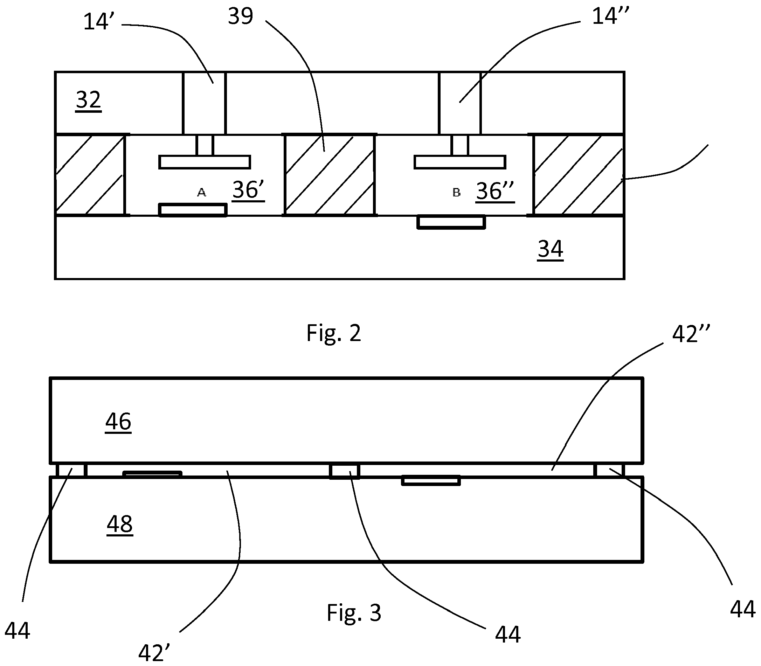

Fig. 2 shows an embodiment wherein the first and second wafers 32, 34 are flat and wherein the cavities 36', 36" are formed by providing an intermediate wafer 38 having an opening accommodating the functional component(s) if present, and wherein the opening optionally has at least one divider member 39 functioning as a partition wall to seal the cavities hermetically from each other upon bonding the first and second wafers with the intermediate wafer.

In fig. 3 another possibility is shown. Here cavities 42', 42" are provided simply by employing the bonding material 44 as a spacer between wafers 46, 48. This method will create a cavity wherein the distance between wafers 46, 48 is in the order of a few µm, suitably about 5 µm or less.

In its most general aspect the invention provides a structure 40 having at least two cavities 20', 20" with different atmospheres, in terms of composition and/or pressure. This can be achieved in different ways.

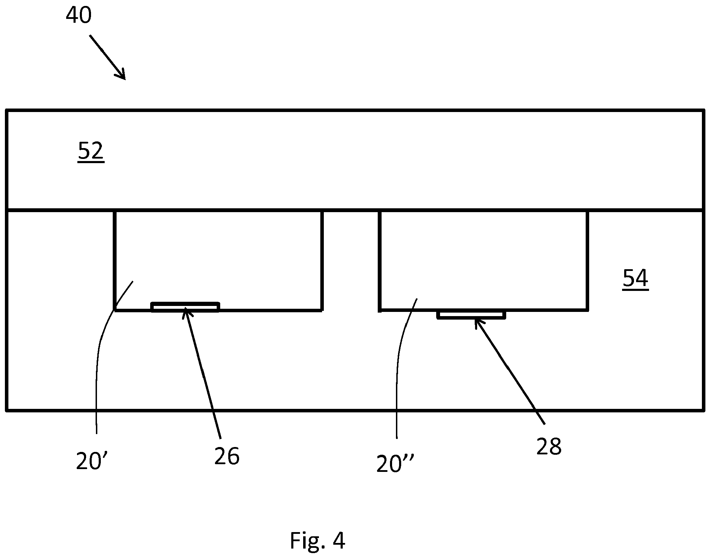

Fig. 4 illustrates providing a getter material 26 in one cavity 20' and a region having implanted atoms or ions of a gaseous species in another cavity 20" in a MEMS device 40. When the device 40 is subjected to appropriate conditions, normally an elevated temperature, the getter is activated and the implanted species are released. This will ascertain a low pressure in the first cavity 20' and a selected atmosphere at a controlled pressure in the other cavity 20".

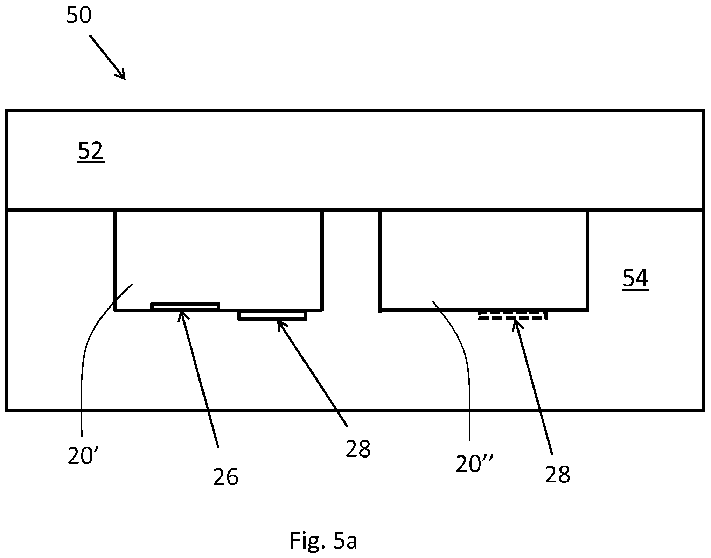

Fig. 5a illustrates an embodiment of a MEMS device 50 wherein a getter 26 and implanted species 28 are provided in one cavity, whereas the other is either devoid of either or possibly only provided with implanted material 28. In this way it is possible to fine tune the atmosphere in the first cavity 20' and to maintain a low pressure in the second cavity 20".

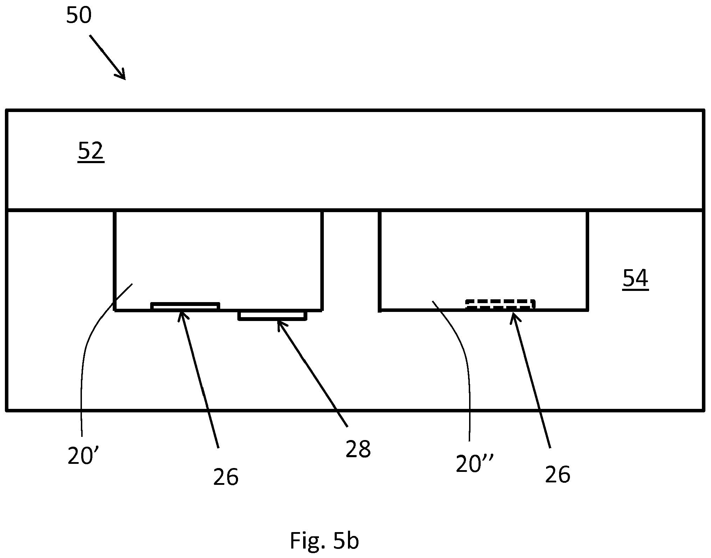

Fig. 5b is similar to Fig. 5a, but instead of implanted material the second cavity contains an (optional) getter 26.

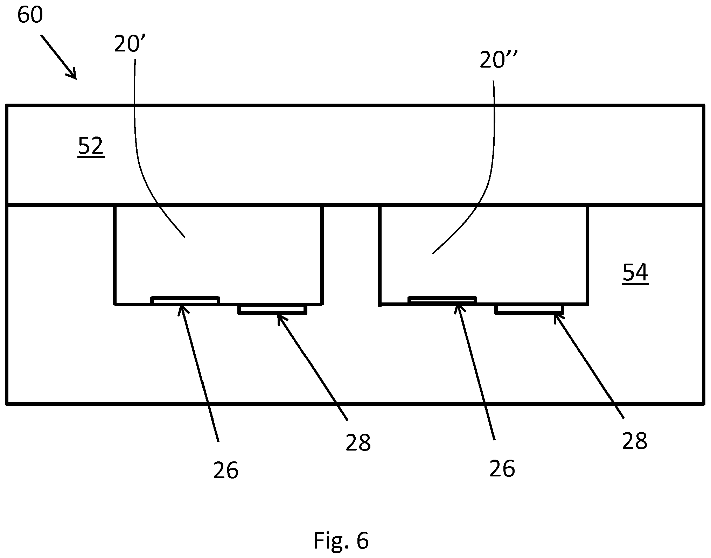

Fig. 6 illustrates an embodiment of a MEMS device 60 wherein a getter 26 and implanted species are provided in both cavities.

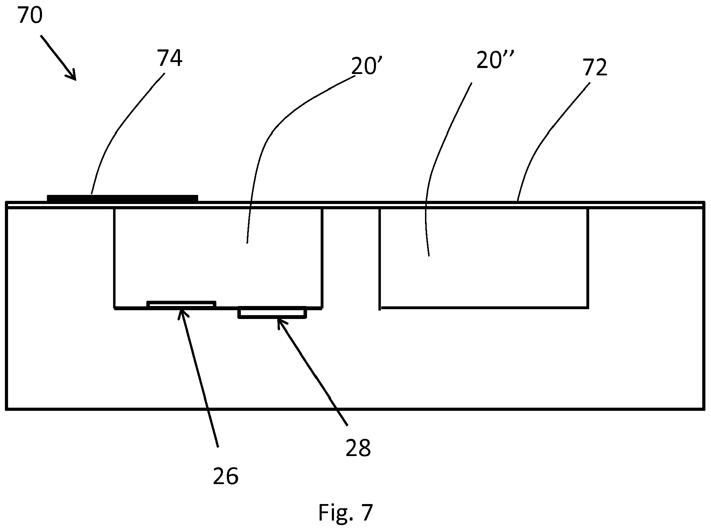

Fig. 7 schematically shows a MEMS device 70 wherein there is provided a thin membrane 72 covering the cavities 20', 20" and wherein there is a strain gauge 74, e.g. a piezo-resistive element, attached to the membrane 72. One cavity 20' is provided with a getter 26 and implanted gas species 28.

Other combinations of getter and implanted materials not explicitly disclosed herein are possible and within the inventive concept.

For example both the walls of cavities and the surface of the "lid" wafer (second wafer) can be provided with getter material and/or implanted material. This is schematically illustrated in Fig. 8, wherein getter material 26 and implanted material 28 are provided on the walls of a first cavity 20', i.e. surfaces of the first wafer 52, and on/in the "roof" of the second cavity, i.e. on/in a surface of the second wafer 54.

The number of cavities having different atmospheres is in principle only limited by the number of cavities that is possible to make on a wafer. If desired a matrix of a very large number of cavities can be made, where each exhibits a unique atmosphere.

### EXAMPLES

The effect of various combinations of amount of getter material and implanted Argon on pressure in cavities was investigated using two wafers W#6 and W#14, respectively.

Both wafers had the same design of cavities as shown in Fig. 1.

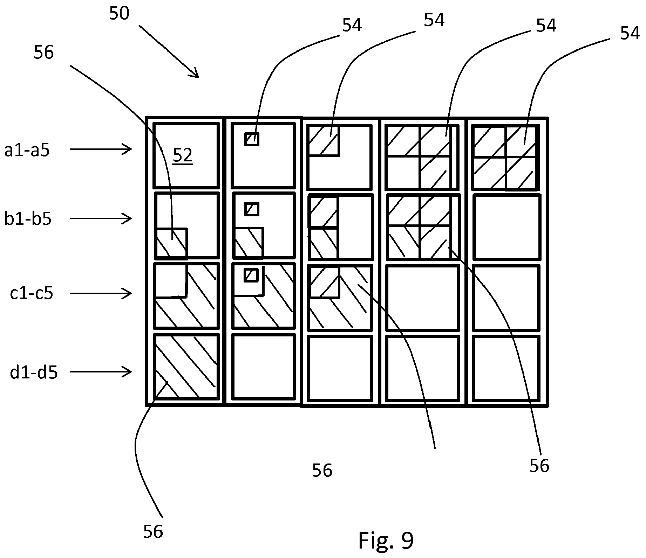

Thus, Fig. 9 shows a part of a wafer 50 having a plurality of cavities 52, respectively, each provided with different combinations of regions 54 with Argon implanted (///) and regions 56 with getter materials (\\\), and each having a PCM for measurements (not shown). In all examples (i.e. both test wafers W#6 and W#14) the cavity 52 is used for measuring pressure variations as a function of different combinations of getter and implanted Argon.

In the first row (a1-a5), wherein each letter represents a cavity structure 52, a 1 contains no material at all, i.e. neither getter nor implanted species, and in a2-a5 there are only regions 54 with increasing amounts of Argon implanted. In a2 5% of the left cavity 52 bottom surface has been subjected to implanting of Argon, in a3 25% of the cavity bottom area is implanted, in a4 75% of the bottom area is implanted and in a5 the entire cavity bottom (i.e. 100%) is implanted with Argon.

In the second row cavities 52 (b1-b4) contain a deposited getter material 56 covering 25% of the cavity bottom, b1 contains no Argon, and b2-b4 contains increasing amounts of Argon. 5%, 25% and 75%, respectively, of the cavity bottom surface has been treated in the same way as in the first row (a1 - a4).

The third row exhibits three cavities c1-c3 wherein cavities 52 contain 75% getter material and wherein c1 contains no Argon, in c2 5% of the bottom area was subjected to implanting and in c3 25% of the cavity bottom was implanted with Argon.

Last row has one cavity d 1 with 100% getter and no Argon on the bottom.

Fig. 10 shows a measurement of the pressure in the respective cavities a1-d1, for both test wafers W#6, W#14, i.e. with no getter or different amounts of getter present. It is clear that varying the getter size (or amount) has an impact on the pressure in the cavities. However, there seems to be no linear area dependency, and thus it is believed that the gettering effect is limited by some other phenomena.

In Fig. 11 the pressure inside cavities (a1 - a5) as a function of amount of implanted Argon (Ar) is shown. None or only a very small effect on pressure from the Ar outgassing area can be seen in the diagrams for both wafers. The reason is most likely that the internal pressure in the cavities is already high so the amount of Ar from outgassing sites is negligible in comparison.

Fig. 12 shows the effect on the pressure of varying the amount of implanted Argon and having 25% getter in all cavities, i.e. b1-b5. The impact is clear in that the pressure increases with increasing amount of implanted Argon.

Thus, a conclusion from the above examples is that a combination of some getter and implanted Argon will enable controlling the atmosphere in cavities, and most importantly that different cavities on one and the same chip can be made to exhibit different pressures.

## Claims

1. A method of making a MEMS device comprising at least two cavities each cavity having a different atmosphere in its respective cavity, the method comprising
providing a first wafer and a sealing structure;
implanting atoms or ions of one or more gaseous species in a surface of at least one of the first wafer and the sealing structure in a limited area thereof, and
providing a gettering structure on at least one of the first wafer and the sealing structure in areas where no implanting of said atoms or ions has been made, and
sealing the first wafer with the sealing structure such that sealed cavities are created between said first wafer and the sealing structure; and
subjecting the resulting structure to conditions so as to activate the getter and/or to release the implanted gaseous species, wherein
the relative amounts of getter and implanted atoms or ions of one or more gaseous species are selected such that different pressures and/or atmospheres will prevail in the cavities.

2. The method according to claim 1, wherein the sealing structure is a second wafer.

3. The method according to claim 1, wherein the sealing structure is a membrane.

4. The method according to claim 1, 2 or 3, wherein the gettering structure is a deposited material, preferably a metal such as Zr, Ti, Nb, Ta, V; an alloy of these metals or one or more of these elements and additional element(s), preferably selected from Cr, Mn, Fe, Co, Ni, Al, Y, La and rare-earths, like binary alloys Ti-V, Zr-V, Zr-Fe and Zr-Ni, ternary alloys like Zr-Mn-Fe or Zr-V-Fe, or alloys with more components, preferably the getter material is titanium or zirconium.

5. The method according to claim 1, 2 or 3, wherein the gettering structure is a modified surface of wafer material.

6. A method of making a MEMS device comprising at least two cavities each cavity having a different atmosphere in its respective cavity, the method comprising
providing a first wafer and a second wafer;
implanting atoms or ions of one or more gaseous species in a surface of at least one of the wafers in a limited area thereof, and
providing a gettering structure on at least one of the wafers in areas where no implanting of said atoms or ions has been made, and
bonding the wafers together such that sealed cavities are created between said wafers; and
subjecting the resulting structure to conditions so as to activate the getter and/or to release the implanted gaseous species, wherein
the relative amounts of getter and implanted atoms or ions of one or more gaseous species are selected such that different pressures and/or atmospheres will prevail in the cavities.

7. The method according to claim 6, wherein the steps of implanting atoms or ions and providing a gettering material are performed in different cavities.

8. The method according to claim 6, wherein the steps of implanting atoms or ions and providing a gettering material are performed in at least one cavity and at least one other cavity is not subjected to either implanting or providing a gettering material.

9. The method according to claim 6, wherein the steps of implanting atoms or ions and providing a gettering material are performed in a plurality of cavities, wherein some cavities are subjected to both steps, some cavities are subjected to either step, and some cavities are not subjected to either.

10. The method according to claim 6, wherein the first and second wafers are flat and wherein the cavities are formed by providing an intermediate wafer having an opening, and wherein the opening optionally has at least one divider member functioning as a partition wall to seal the cavities hermetically from each other upon bonding, or wherein at least one of the first and second wafers have divider elements functioning as a partition wall to seal the cavities hermetically from each other, upon bonding with the intermediate wafer.

11. The method according to claim 6, wherein at least one of the first and second wafers have depression(s) formed in their surface, wherein the cavities are formed by bonding the wafers together, wherein there is/are provided (a) divider element(s) functioning as (a) partition wall(s) to seal the cavities hermetically from each other upon bonding.

12. The method according to claim 6, wherein the first and second wafers are flat and wherein the cavities are formed in that the bonding material acts as a spacer.

13. The method according to any preceding claim, further comprising providing a functional component in at least one cavity.

14. The method according to claim 13, wherein said functional component is selected from the group consisting of gyro, an accelerometer, a strain gauge, a piezoresistive component, pressure sensors, bolometers, MUT (Micromachined Ultrasonic Transducer), gas sensors.

15. The method according to any preceding claim, wherein the cavities are placed side by side on the same height.

16. MEMS device comprising at least two cavities each having a different pressure and/or atmosphere, **characterized in that** the respective pressure and/or atmosphere has been obtained by the provision of either a gettering material or an outgassing material or a combination thereof in at least one of the cavities.

17. MEMS device according to claim 16, further comprising a functional component in at least one cavity.

18. MEMS device according to claim 16 or 17, wherein said functional component is selected from the group consisting of gyro, an accelerometer, a strain gauge, a piezoresistive component, pressure sensors, bolometers, MUT (Micromachined Ultrasonic Transducer), gas sensors.

19. MEMS device according to any of claims 16-18, further comprising at least one via (14) extending between a cavity and the outside of the MEMS device.

20. MEMS device according to any of claims 16-19, wherein the pressure and/or atmosphere in a first cavity has been obtained by the provision of either a gettering material or an outgassing material or a combination thereof; and wherein the pressure and/or atmosphere in a second cavity has been obtained by the provision of a gettering material or an outgassing material or a combination thereof, which is different from that of the first cavity.
